Europäisches Patentamt
European Patent Office
Office européen des brevets

(11) Publication number: 0 354 963 A1

# EUROPEAN PATENT APPLICATION published in accordance with Art. 158(3) EPC

(21) Application number: 88908347.3

(22) Date of filing: 21.09.88

(86) International application number: PCT/JP88/00956

(87) International publication number: WO 89/02880 (06.04.89 89/08)

(51) Int. Cl.[4] C04B 35/00 , C01G 3/00 , H01B 12/00

(30) Priority: 24.09.87 JP 239706/87
29.01.88 JP 19053/88

(43) Date of publication of application: 21.02.90 Bulletin 90/08

(84) Designated Contracting States: DE FR GB

(71) Applicant: MITSUBISHI KINZOKU KABUSHIKI KAISHA
5-2, Otemachi 1-chome
Chiyoda-ku Tokyo 100(JP)

(72) Inventor: TAKESHITA, Takuo
Mitsubishi Kinzoku K. K. Chuo Kenkyujo 297
Kitabukurocho 1-chome Saitama 330(JP)
Inventor: HAGINO, Sadaaki Mitsubishi Kinzoku K. K.
Chuo Kenkyujo 297, Kitabukurocho 1-chome
Omiya-shi Saitama 330(JP)
Inventor: SAKURAI, Takeshi Mitsubishi Kinzoku K. K.
Chuo Kenkyojo 297, Kitabukurocho 1-chome
Omiya-shi Saitama 330(JP)
Inventor: SUGIHARA, Tadashi Mitsubishi Kinzoku K. K.
Chuo Kenkyojo 297, Kitabukurocho 1-chome
Omiya-shi, Saitama 330(JP)

(74) Representative: Glawe, Delfs, Moll & Partner
Patentanwälte
Postfach 26 01 62 Liebherrstrasse 20
D-8000 München 26(DE)

## (54) PROCESS FOR PRODUCING SUPERCONDUCTIVE CERAMIC SINTER.

(57) A process for producing superconductive ceramic sinter according to the invention comprises compounding a first powder of oxide(s) containing rare earth metal element(s), a second powder of oxide(s) or carbonate(s) of alkaline earth metal element(s), a third powder of copper oxide, and a fourth powder of metal fluoride in predetermined proportions, baking the resulting mixed powder to produce superconductive ceramic, molding a powder of said ceramic, and sintering the molding. The presence of the metal fluoride in said sinter in a predetermined amount serves to improve the toughness and density

EP 0 354 963 A1

SPECIFICATION

# PROCESS OF PRODUCING SUPERCONDUCTIVE CERAMIC MATERIAL

## TECHNICAL FIELD

This invention relates to a superconductive ceramic material and, more particularly, to a process of producing a superconductive ceramic material having a large strength and a large tenacity.

## BACKGROUND ART

A typical example of the process of producing a superconductive ceramic material starts with preparation of a raw powder of an oxygen compound of a rare earth metal such as, for example, yttrium (which is hereinunder represented by the general formula of $R_2O_3$), a raw powder of an carbonate or an oxygen compound of an alkaline earth metal (which is hereinunder represented by the general formula of $ACO_3$ or AO) and a raw powder of a copper oxide (which is hereinunder represented by the general formula of CuO), and each raw powder is formed of particles having a mean diameter less than 10 microns, mixing the prescribed amounts of raw powders in a predetermined proportion. The mixed powders or the mixtures are heated up in a dried air to a temperature ranging from about 850 degrees to about 950 degrees in centigrade for calcination to produce a superconductive ceramic material, pulverizing the calcined product into a powder containing particles measuring less than 10 microns in mean diameter. Each of the calcination and pulverization is carried out once in this prior-art example, however, they may be repeated more than once. The superconductive ceramic powder thus obtained is pressed into a preselected shape and, then, sintered in an oxidation ambient at a temperature ranging from about 900 degrees to about 980 degrees in centigrade, thereby producing a sintered superconductive ceramic material. The sintered superconductive ceramic material is inserted into a tube of silver or copper for a shaping operation such as a swaging, a grooved roll forming or a drawing, and the tube filled with the sintered superconductive ceramic material is shaped into a wiring member, a conductive plate member, a conductive coil member or a conductive strip member.

However, the sintered superconductive ceramic material produced by the prior-art process is less tenacious, so that cracks or disconnections tend to take place during the shaping operation due to the brittleness. These cracks or disconnections deteriorate the production yield and give rise to decrease the shaping machine in working speed, thereby resulting in reduction in production efficiency.

In addition to the problem described above, the conventional sintered superconductive ceramic material is not greater than 80 percent in theoretical density ratio, and the flexural strength thereof is not greater than 200 $Kg/cm^2$. These also results in cracks and disconnections during the shaping operation and after installation.

It is therefore an important object of the present invention to provide a process of producing a sintered superconductive ceramic material having a large tenacity.

It is also important object of the present invention to provide a process of producing a sintered superconductive ceramic material having a large density.

## DISCLOSURE OF THE INVENTION

The inventors discover that a superconductive ceramic material is improved in tenacity when the raw powders and a powder of a metal fluoride are mixed in a predetermined proportion and that the superconductive ceramic material is increased in density if the metal fluoride is mixed into the raw powders in such a manner as to be in another preselected proportion.

In accordance with the present invention, there is provided a process of producing a sintered superconductive ceramic material comprising the steps of: a) preparing a first powder containing an oxygen compound of a rare earth metal, a second powder containing a compound selected from the group consisting of alkaline earth metal oxides and alkaline earth metal carbonates, a third powder containing a copper oxide and a fourth powder containing a metal fluoride; b) mixing the first, second, third and fourth powders in a predetermined proportion to form a mixture; c) calcining the mixture to produce a superconductive ceramic material; d) pulverizing the superconductive ceramic material to form a powder of the superconductive ceramic material; e) shaping the powder of the superconductive ceramic material into a predetermined configuration; and f) sintering the powder of the superconductive ceramic material shaped into the predetermined configuration to produce a sintered superconductive ceramic material.

When the metal fluoride is mixed with the first, second and third powders in such a manner that the fluorine content of the mixture ranges from about 0.01 % to about 0.35 % by weight, the fluorine content of the sintered superconductive ceramic material is fallen into the range between about 0.01 % and about 0.3 % by weight, so that the sintered superconductive ceramic material is improved in tenacity without sacrifice of the critical current density by virtue of the fluorine atoms in the above range. One of the reasons why the metal fluoride is mixed with the first to third powders so as to cause the fluorine to range in the above is that the tenacity and the critical current density are not improved under a fluorine content of the sintered superconductive ceramic material less than 0.01 % by weight which is resulted from the fluorine content of the mixture less than about 0.01 % by weight. One of the reasons why the fluorine content is selected to be equal to or less than about 0.35 % by weight is that the sintered superconductive ceramic materials are deteriorated in the critical temperature and the critical current density because the fluorine atoms are precipitated from the sintered superconductive ceramic material due to saturation in solubility at 0.3 % by weight which is resulted from the fluorine content of the mixture greater than about 0.35 % by weight.

Moreover, when the mixture holds the metal fluoride ranging between about 1 % and about 20 % by weight, the sintered superconductive ceramic material is increased in theoretical density to be equal to or greater than about 90 %, and, for this reason, the flexural strength thereof is equal to or greater than about 500 $Kg/cm^2$. The reasons why the metal fluoride is mixed in the above proportion are that the sintered superconductive ceramic material resulted from the metal fluoride less than about 1 % by weight is insufficiently increased in the density and that the sintered superconductive ceramic material resulted from the metal fluoride greater than about 20 % by weight is certainly deteriorated in critical temperature and in critical current density.

## BEST MODE FOR CARRYING OUT THE INVENTION

Description is made for examples of the sintered superconductive ceramic materials produced by the process according to the present invention.

First, the process starts with preparing a first powder containing an oxygen compound of a rare earth metal $R_2O_3$, second powders containing an alkaline earth metal oxide AO and an alkaline earth metal carbonate $ACO_3$, respectively, a third powder of a copper oxide CuO and fourth powders respectively containing metal fluorides represented by the molecular formula of $BaF_2$ and $CuF_2$, respectively. Each of the first to fourth powders contains particles having a mean diameter ranging from about 0.5 micron to about 10.0 microns. These powders are mixed in respective proportions shown in Table 1 using a ball-mill. Each of the mixing operations is carried out in a dried condition for about 6 hours, and the resultant mixtures are subjected to respective pressures of about 1 ton/$cm^2$ to be shaped into a predetermined configuration. Thus, a plurality of samples are produced from the respective mixtures and, thereafter, calcined in air at about 900 degrees in centigrade for about 10 hours, thereby producing superconductive ceramic materials. After the first calcining operations, the superconductive ceramic materials are roughly pulverized in a mortar, then repeating the calcinations in the conditions similar to the first calcining operations. The superconductive ceramic materials produced by the second calcining operations are pulverized in a wet ball-mill for about 6 hours, thereby respectively producing powders of the superconductive ceramic materials each containing particles having a mean diameter of about 1.5 micron. Each of the powders is subjected to a pressure of about 2 tons/$cm^2$ to be shaped into a preselected configuration which has a length of about 40 mili-meter, a width of about 8 mili-meter and a thickness of about 4 mili-meter. Each powder shaped into the preselected configuration ( which is hereinunder referred to as " pressurized mixture " ) is sintered in air at about 980 degrees in centigrade for 10 hours, thereby producing a sintered superconductive ceramic material the composition and the properties of which are represented in Table 2.

Table 3 shows respective compositions of mixtures without any metal fluoride used in the prior-art process, and the compositions and the properties of superconductive ceramic materials produced by the prior-art process are shown in Table 4.

As will be understood by comparing Table 2 with Table 4, the sintered superconductive ceramic materials produced by the process of the present invention are improved in tenacity P and in critical temperature Tc, however, they are similar in current density Jc to the sintered superconductive ceramic materials produced by the prior-art process.

(blank)

Table 1

| Sample No. | Composition ( % by weight ) $R_2O_3$ | $ACO_3$ or AO | metal fluoride (F) | CuO |
|---|---|---|---|---|
| 1 | $Y_2O_3$:15.16 | $BaCO_3$:51.32 | $BaF_2$: 1.53(F:1.35) | residue |
| 2 | $Y_2O_3$:16.88 | BaO: 47.16 | $BaF_2$: 0.05(F:0.01) | residue |
| 3 | $Er_2O_3$:25.54 | BaO: 41.25 | $BaF_2$: 1.14(F:0.25) | residue |
| 4 | $Dy_2O_3$:25.53 | BaO: 41.86 | $BaF_2$: 0.96(F:0.20) | residue |
| 5 | $Gd_2O_3$:27.60 | $BaCO_3$:47.99 | $BaF_2$: 0.62(F:0.13) | residue |
| 6 | $Yb_2O_3$:26.61 | BaO: 42.21 | $CuF_2$: 0.49(F:0.20) | residue |
| 7 | $Tm_2O_3$:26.65 | BaO: 42.04 | $BaF_2$: 0.06(F:0.02) | residue |
| 8 | $Nd_2O_3$:20.67 | $BaCO_3$:48.12 | $BaF_2$:1.27(F:0.30) | residue |
| 9 | $Lu_2O_3$:23.83 | $BaCO_3$:45.68 | $BaF_2$:1.73(F:0.35) | residue |
| 10 | $Sm_2O_3$:21.67 | $BaCo_3$:47.50 | $BaF_2$:1.11(F:0.25) | residue |
| 11 | $Y_2O_3$:17.37 | BaO:43.22<br>SrO:2.85 | $CuF_2$:0.87(F:0.32) | residue |
| 12 | $Lu_2O_3$:21.80 | BaO:28.91<br>SrO:23.21 | $CuF_2$:0.20(F:0.08) | residue |

(blank)

Table 2

| Sample No. | Composition of sintered superconductive ceramic material (% by weight) | | | | | Properties of superconductive ceramic material | | | |
|---|---|---|---|---|---|---|---|---|---|
| | R | A | O | F | Cu | TD (%) | P (Kg/cm²) | Tc (kelvin) | Jc (A/cm²) |
| 1 | Y: 13.85 | Ba: 42.66 | 13.55 | 0.30 | residue | 93.5 | 150 | 95 | 720 |
| 2 | Y: 13.37 | Ba: 41.19 | 16.80 | 0.01 | residue | 90.0 | 200 | 95 | 500 |
| 3 | Er: 22.26 | Ba 36.99 | 14.85 | 0.19 | residue | 85.1 | 180 | 98 | 670 |
| 4 | Dy: 22.25 | Ba: 37.38 | 14.93 | 0.17 | residue | 88.4 | 190 | 97 | 620 |
| 5 | Gd: 22.05 | Ba: 37.94 | 14.18 | 0.10 | residue | 79.0 | 180 | 95 | 480 |
| 6 | Yb: 23.37 | Ba: 36.76 | 14.73 | 0.15 | residue | 82.0 | 140 | 96 | 350 |
| 7 | Tm: 18.37 | Ba: 36.74 | 18.61 | 0.01 | residue | 74.0 | 160 | 97 | 390 |
| 8 | Nd: 16.28 | Ba: 38.63 | 18.00 | 0.25 | residue | 89.0 | 180 | 95 | 560 |
| 9 | Lu: 23.43 | Ba: 36.89 | 13.70 | 0.29 | residue | 88.0 | 120 | 98 | 860 |
| 10 | Sm: 20.96 | Ba: 37.94 | 14.33 | 0.16 | residue | 90.2 | 180 | 97 | 840 |
| 11 | Y: 13.68 | Ba: 37.72 Sr: 2.41 | 16.68 | 0.28 | residue | 94.2 | 160 | 96 | 750 |
| 12 | Lu: 19.17 | Ba: 24.78 Sr: 19.55 | 15.14 | 0.05 | residue | 92.0 | 140 | 95 | 870 |

In the Table 2, TD stands for the theoretical density ratio.

Table 3

| Sample No. | Composition $R_2O_3$ | $ACO_3$ | metal fluoride | CuO |
|---|---|---|---|---|
| 21 | $Y_2O_3$: 15.16 | $BaCO_3$: 52.85 | None | residue |
| 22 | $Y_2O_3$: 16.88 | BaO: 47.21 | None | residue |
| 23 | $Er_2O_3$:25.54 | BaO: 42.39 | None | residue |
| 24 | $Dy_2O_3$:25.53 | BaO: 42.83 | None | residue |
| 25 | $Gd_2O_3$:27.60 | $BaCO_3$: 48.62 | None | residue |
| 26 | $Yb_2O_3$:26.61 | BaO: 42.21 | None | residue |
| 27 | $Tm_2O_3$:25.65 | BaO: 42.10 | None | residue |
| 28 | $Nd_2O_3$:20.67 | $BaCO_3$: 49.39 | None | residue |
| 29 | $Lu_2O_3$:23.83 | $BaCO_3$: 47.42 | None | residue |
| 30 | $Sm_2O_3$:21.67 | $BaCO_3$: 48.61 | None | residue |
| 31 | $Y_2O_3$: 17.37 | BaO: 43.22<br>SrO: 2.85 | None | residue |
| 32 | $Lu_2O_3$: 21.80 | BaO: 28.90<br>SrO: 23.21 | None | residue |

(blank)

Table 4

| Sample No. | Composition of sintered superconductive ceramic material (% by weight) | | | | | Properties of superconductive ceramic material | | | |
|---|---|---|---|---|---|---|---|---|---|
| | R | A | O | F | Cu | TD (%) | P (Kg/cm$^2$) | Tc (kelvin) | Jc (A/cm$^2$) |
| 21 | Y: 13.85 | Ba: 42.66 | 13.85 | 0 | residue | 67.2 | 90 | 92 | 720 |
| 22 | Y: 13.37 | Ba 41.19 | 16.82 | 0 | residue | 79.1 | 170 | 91 | 480 |
| 23 | Er: 22.26 | Ba: 36.99 | 15.07 | 0 | residue | 76.4 | 130 | 95 | 630 |
| 24 | Dy: 22.25 | Ba: 37.38 | 15.10 | 0 | residue | 74.0 | 130 | 94 | 590 |
| 25 | Gd: 22.05 | Ba: 37.94 | 14.28 | 0 | residue | 74.1 | 150 | 92 | 420 |
| 26 | Yb: 23.37 | Ba: 36.76 | 14.89 | 0 | residue | 65.6 | 100 | 91 | 340 |
| 27 | Tm: 18.37 | Ba: 36.74 | 18.62 | 0 | residue | 71.3 | 120 | 90 | 390 |
| 28 | Nd: 16.28 | Ba: 38.63 | 18.26 | 0 | residue | 69.2 | 120 | 91 | 550 |
| 29 | Lu: 23.43 | Ba: 36.89 | 14.00 | 0 | residue | 64.0 | 80 | 94 | 850 |
| 30 | Sm: 20.96 | Ba: 37.94 | 14.48 | 0 | residue | 73.4 | 140 | 95 | 840 |
| 31 | Y: 13.68 | Ba: 37.72 Sr: 2.41 | 16.98 | 0 | residue | 77.5 | 150 | 93 | 740 |
| 32 | Lu: 19.17 | Ba: 24.78 Sr: 19.55 | 15.19 | 0 | residue | 76.3 | 130 | 92 | 840 |

In Table 4, TD stands for the theoretical density ratio.

Subsequently, description is made for sintered superconductive ceramic materials each produced from a mixture containing a metal fluoride ranging from about 1 % to about 20 % by weight for improvement in density.

The process starts with preparation of a first powder containing $R_2O_3$, a second powder containing $ACO_3$, a second powder containing AO, a third powder containing CuO and various fourth powders respectively containing metal fluorides. Each powder containing particles having a mean diameter ranging from about 0.5 micron to about 10.0 microns. The powders are mixed into respective proportions shown in Table 5 to produce respective mixtures. Each of the mixtures is subjected to a pressure of about 1 ton/$cm^2$ and, accordingly, shaped into a predetermined configuration. The pressurized mixtures are calcined in air at about 900 degrees in centigrade for about 30 hours, thereby producing superconductive ceramic materials, respectively. Each of the superconductive ceramic materials is pulverized to produce a powder of the superconductive ceramic material which contains particles having a mean diameter equal to or less than about 5 microns. Each powder of the superconductive ceramic material is subjected to a pressure of about 2 tons/$cm^2$ to shape into a preselected configuration which has a length of about 40 mili-meter, a width of about 8 mili-meter and a thickness of about 4 mili-meter. These pressurized powders are sintered in air at a temperature ranging between about 900 degrees and about 980 degrees in centigrade for about 10 hours, thereby producing sintered superconductive ceramic materials, respectively. Measurements are carried out for determination of the properties of each sintered superconductive ceramic material, and the results are shown in Table 6.

Table 7 shows respective compositions of mixtures used in the prior-art process, and each mixture does not contain any metal fluoride. Sintered superconductive ceramic materials are produced from the mixtures shown in Table 7 by using the sequential steps similar to those described hereinbefore. The sintered superconductive ceramic materials are also measured to determine the properties thereof, and the results are shown in Table 8 for comparison with the sintered superconductive ceramic materials produced by the process of the present invention.

Comparing the results shown in Table 6 with the results shown in Table 8, it will be understood that the sintered superconductive ceramic materials produced by the the process of the present invention are larger in density than the sintered super conductive ceramic materials produced by the prior-art process. By virtue of the large density, each sintered superconductive ceramic material in turn has a larger flexural strength than the prior-art superconductive ceramic materials.

TABLE 5

| Sample No. | Composition ( % by weight ) $R_2O_3$ | $ACO_3$ or AO | metal fluoride | CuO |
|---|---|---|---|---|
| 41 | $Y_2O_3$:15.2 | $BaCO_3$:52.3 | $BaF_2$: 1 | residue |
| 42 | $Y_2O_3$:15.2 | $BaCO_3$:50.8 | $BaF_2$: 2 | residue |
| 43 | $Y_2O_3$:15.2 | $BaCO_3$:47.6 | $BaF_2$: 5 | residue |
| 44 | $Y_2O_3$:15.3 | $BaCO_3$:42.2 | $BaF_2$:10 | residue |
| 45 | $Y_2O_3$:15.4 | $BaCO_3$:36.7 | $BaF_2$:15 | residue |
| 46 | $Y_2O_3$:15.5 | $BaCO_3$:31.2 | $BaF_2$:20 | residue |
| 47 | $Y_2O_3$:16.9 | BaO:37.3 | $BaF_2$:10 | residue |
| 48 | $Er_2O_3$:13.7 | BaO:42.9 | $YF_3$:10 | residue |
| 49 | $Dy_2O_3$:42.9 | BaO:41.0 | $CuF_2$:10 | residue |
| 50 | $Yb_2O_3$:26.2 | BaO:32.0 | $BaF_2$:10 | residue |
| 51 | $Gd_2O_3$:16.1 | $BaCO_3$:48.5 | $YF_3$: 5<br>$CuF_2$: 5 | residue |
| 52 | $Tm_2O_3$:12.8 | BaO:43.0 | $YF_3$:10 | residue |
| 53 | $Nd_2O_3$:21.3 | $BaCO_3$:38.6 | $BaF_2$:10 | residue |
| 54 | $Lu_2O_3$:23.8 | $BaCO_3$:41.6 | $BaF_2$: 5<br>$CuF_2$: 5 | residue |
| 55 | $Sm_2O_3$:23.7 | BaO:41.7 | $CuF_2$:10 | residue |
| 56 | $Y_2O_3$:15.8 | BaO:30.6<br>SrO: 2.9 | $BaF_2$:10 | residue |
| 57 | $Lu_2O_3$:18.1 | $BaCO_3$:21.7<br>CaO: 0.7 | $BaF_2$: 5<br>$YF_3$: 5 | residue |

(blank)

Table 6

| Sample No. | Properties of sintered superconductive ceramic material | | | |
|---|---|---|---|---|
| | Theoretical density ratio(%) | Flexural strength (Kg/cm$^2$) | Critical temperature (in Kelvin scale) | Critical current density (A/cm$^2$) |
| 41 | 93.5 | 620 | 93 | 810 |
| 42 | 94.0 | 540 | 92 | 750 |
| 43 | 95.1 | 630 | 95 | 540 |
| 44 | 94.9 | 550 | 98 | 620 |
| 45 | 95.0 | 590 | 91 | 650 |
| 46 | 94.5 | 650 | 88 | 420 |
| 47 | 95.5 | 700 | 93 | 560 |
| 48 | 96.3 | 820 | 95 | 480 |
| 49 | 95.2 | 650 | 92 | 420 |
| 50 | 94.3 | 540 | 94 | 610 |
| 51 | 96.3 | 750 | 93 | 750 |
| 52 | 95.5 | 540 | 95 | 860 |
| 53 | 94.9 | 600 | 94 | 710 |
| 54 | 96.1 | 930 | 92 | 620 |
| 55 | 97.5 | 1430 | 96 | 590 |
| 56 | 91.8 | 620 | 95 | 750 |
| 57 | 93.7 | 830 | 94 | 740 |

(blank)

TABLE 7

| Sample No. | Composition ( % by weight ) $R_2O_3$ | ACO$_3$ or AO | metal fluoride | CuO |
|---|---|---|---|---|
| 61 | $Y_2O_3$:15.1 | $BaCO_3$:52.9 | none | residue |
| 62 | $Y_2O_3$:17.1 | BaO:44.2 | none | residue |
| 63 | $Er_2O_3$:26.0 | BaO:41.6 | none | residue |
| 64 | $Dy_2O_3$:25.5 | BaO:41.9 | none | residue |
| 65 | $Yb_2O_3$:26.5 | BaO:41.3 | none | residue |
| 66 | $Gd_2O_3$:22.2 | $BaCO_3$:48.5 | none | residue |
| 67 | $Tm_2O_3$:26.1 | BaO:41.5 | none | residue |
| 68 | $Nd_2O_3$:21.0 | $BaCO_3$:49.2 | none | residue |
| 69 | $Lu_2O_3$:23.9 | $BaCO_3$:47.4 | none | residue |
| 70 | $Sm_2O_3$:24.2 | BaO:42.6 | none | residue |
| 71 | $Y_2O_3$:17.4 | BaO:42.6<br>SrO: 3.2 | none | residue |
| 72 | $Lu_2O_3$:24.3 | $BaCO_3$:45.8<br>CaO: 0.7 | none | residue |

(blank)

Table 8

| Sample No. | Properties of sintered superconductive ceramic material | | | |
|---|---|---|---|---|
| | Theoretical density ratio(%) | Flexural strength ($Kg/cm^2$) | Critical temperature (in Kelvin scale) | Critical current density ($A/cm^2$) |
| 61 | 67.2 | 90 | 92 | 720 |
| 62 | 79.1 | 170 | 91 | 480 |
| 63 | 76.4 | 130 | 95 | 630 |
| 64 | 74.0 | 130 | 97 | 590 |
| 65 | 74.1 | 150 | 93 | 420 |
| 66 | 65.6 | 110 | 92 | 340 |
| 67 | 71.3 | 130 | 95 | 390 |
| 68 | 69.2 | 120 | 94 | 550 |
| 69 | 64.0 | 70 | 97 | 850 |
| 70 | 73.4 | 140 | 96 | 860 |
| 71 | 77.5 | 190 | 93 | 740 |
| 72 | 76.3 | 150 | 92 | 730 |

## INDUSTRIAL APPLICABILITY

The process of producing a sintered superconductive ceramic material according to the present invention is applicable to a sintered superconductive ceramic material used for forming a wiring and a conductive strip.

CLAIMS

1. A process of producing a sintered superconductive ceramic material comprising the steps of:

a) preparing a first powder containing an oxygen compound of a rare earth metal, a second powder containing a compound selected from the group consisting of alkaline earth metal oxides and alkaline earth metal carbonates, a third powder containing a copper oxide and a fourth powder containing a metal fluoride;

b) mixing said first, second, third and fourth powders in a predetermined proportion to form a mixture;

c) calcining said mixture to produce a superconductive ceramic material;

d) pulverizing said superconductive ceramic material to form a powder of said superconductive ceramic material;

e) shaping said powder of said superconductive ceramic material into a predetermined configuration; and

f) sintering said powder of said superconductive ceramic material shaped into said predetermined configuration to produce a sintered superconductive ceramic material.

2. A process of producing a sintered superconductive ceramic material as set forth in claim 1, in which the fluorine content of said sintered superconductive ceramic material ranges from about 0.01 % to about 0.30 % by weight.

3. A process of producing a sintered superconductive ceramic material as set forth in claim 2, in which the fluorine content of said mixture ranges from about 0.01 % to about 0.35 % by weight.

4. A process of producing a sintered superconductive ceramic material as set forth in claim 3, in which said oxygen compound of said rare earth metal in said first powder, said alkaline earth metal carbonate in said second powder and said metal fluoride in said fourth powder are respectively represented by the molecular formulas of $Y_2O_3$, $BaCO_3$ and $BaF_2$.

5. A process of producing a sintered superconductive ceramic material as set forth in claim 4, in which said mixture holds about 15.16 % of the oxygen compound of said rare earth metal by weight, about 51.32 % of said alkaline earth metal carbonate by weight and about 1.53 % of said metal fluoride by weight, respectively.

6. A process of producing a sintered superconductive ceramic material as set forth in claim 3, in which said said oxygen compound of said rare earth metal in said first powder, said alkaline earth metal oxide in said second powder and said metal fluoride in said fourth powder are respectively represented by the molecular formulas of $Y_2O_3$, BaO and $BaF_2$.

7. A process of producing a sintered superconductive ceramic material as set forth in claim 6, in which said mixture holds about 16.88 % of the oxygen compound of said rare earth metal by weight, about 47.16 % of said alkaline earth metal oxide by weight and about 0.05 % of said metal fluoride by weight, respectively.

8. A process of producing a sintered superconductive ceramic material as set forth in claim 3, in which said oxygen compound of said rare earth metal in said first powder, said alkaline earth metal oxide in said second powder and said metal fluoride in said fourth powder are respectively represented by the molecular formulas of $Er_2O_3$, BaO and $BaF_2$.

9. A process of producing a sintered superconductive ceramic material as set forth in claim 8, in which said mixture holds about 25.54 % of the oxygen compound of said rare earth metal by weight, about 41.25 % of said alkaline earth metal oxide by weight and about 1.14 % of said metal fluoride by weight, respectively.

10. A process of producing a sintered superconductive ceramic material as set forth in claim 3, in which said oxygen compound of said rare earth metal in said first powder, said alkaline earth metal oxide in said second powder and said metal fluoride in said fourth powder are respectively represented by the molecular formulas of $Dy_2O_3$, BaO and $BaF_2$.

11. A process of producing a sintered superconductive ceramic material as set forth in claim 10, in which said mixture holds about 25.53 % of the oxygen compound of said rare earth metal by weight, about 41.86 % of said alkaline earth metal oxide by weight and about 0.96 % of said metal fluoride by weight, respectively.

12. A process of producing a sintered superconductive ceramic material as set forth in claim 3, in which said oxygen compound of said rare earth metal in said first powder, said alkaline earth metal carbonate in said second powder and said metal fluoride in said fourth powder are respectively represented by the molecular formulas of $Gd_2O_3$, $BaCO_3$ and $BaF_2$.

13. A process of producing a sintered superconductive ceramic material as set forth in claim 12, in which said mixture holds about 27.60 % of the oxygen compound of said rare earth metal by weight, about 47.99 % of said alkaline earth metal carbonate by weight and about 0.62 % of said metal fluoride by weight, respectively.

14. A process of producing a sintered superconductive ceramic material as set forth in claim 3, in which said oxygen compound of said rare earth metal in said first powder, said alkaline earth metal oxide in said second powder and said metal fluoride in said fourth powder are respectively represented by the molecular formulas of $Yb_2O_3$, BaO and $CuF_2$.

15. A process of producing a sintered superconductive ceramic material as set forth in claim 14, in which said mixture holds about 26.61 % of the oxygen compound of said rare earth metal by weight, about 42.21 % of said alkaline earth metal oxide by weight and about 0.49 % of said metal fluoride by weight, respectively.

16. A process of producing a sintered superconductive ceramic material as set forth in claim 3, in which said oxygen compound of said rare earth metal in said first powder, said alkaline earth metal oxide in said second powder and said metal fluoride in said fourth powder are respectively represented by the molecular formulas of $Tm_2O_3$, BaO and $BaF_2$.

17. A process of producing a sintered superconductive ceramic material as set forth in claim 16, in which said mixture holds about 26.65 % of the oxygen compound of said rare earth metal by weight, about 42.04 % of said alkaline earth metal oxide by weight and about 0.06 % of said metal fluoride by weight, respectively.

18. A process of producing a sintered superconductive ceramic material as set forth in claim 3, in which said oxygen compound of said rare earth metal in said first powder, said alkaline earth metal carbonate in said second powder and said metal fluoride in said fourth powder are respectively represented by the molecular formulas of $Nd_2O_3$, $BaCO_3$ and $BaF_2$.

19. A process of producing a sintered superconductive ceramic material as set forth in claim 18, in which said mixture holds about 20.67 % of the oxygen compound of said rare earth metal by weight, about 48.12 % of said alkaline earth metal carbonate by weight and about 1.27 % of said metal fluoride by weight, respectively.

20. A process of producing a sintered superconductive ceramic material as set forth in claim 3, in which said oxygen compound of said rare earth metal in said first powder, said alkaline earth metal carbonate in said second powder and said metal fluoride in said fourth powder are respectively represented by the molecular formulas of $Lu_2O_3$, $BaCO_3$ and $BaF_2$.

21. A process of producing a sintered superconductive ceramic material as set forth in claim 20, in which said mixture holds about 23.83 % of the oxygen compound of said rare earth metal by weight, about 45.68 % of said alkaline earth metal carbonate by weight and about 1.73 % of said metal fluoride by weight, respectively.

22. A process of producing a sintered superconductive ceramic material as set forth in claim 3, in which said oxygen compound of said rare earth metal in said first powder, said alkaline earth metal carbonate in said second powder and said metal fluoride in said fourth powder are respectively represented by the molecular formulas of $Sm_2O_3$, $BaCO_3$ and $BaF_2$.

23. A process of producing a sintered superconductive ceramic material as set forth in claim 22, in which said mixture holds about 21.67 % of the oxygen compound of said rare earth metal by weight, about 47.50 % of said alkaline earth metal carbonate by weight and about 1.11 % of said metal fluoride by weight, respectively.

24. A process of producing a sintered superconductive ceramic material as set forth in claim 3, in which said oxygen compound of said rare earth metal in said first powder, said alkaline earth metal oxide in said second powder and said metal fluoride in said fourth powder are respectively represented by the molecular formulas of $Y_2O_3$, BaO and $CuF_2$ and in which said second powder further contains an alkaline earth metal oxide represented by the molecular formula of SrO.

25. A process of producing a sintered superconductive ceramic material as set forth in claim 24, in which said mixture holds about 17.37 % of the oxygen compound of said rare earth metal by weight, about 43.22 % of said alkaline earth metal oxide represented by the molecular formula of BaO by weight, about 2.85 % of said alkaline earth metal oxide represented by the molecular formula of SrO by weight, and about 0.87 % of said metal fluoride by weight, respectively.

26. A process of producing a sintered superconductive ceramic material as set forth in claim 3, in which said oxygen compound of said rare earth metal in said first powder, said alkaline earth metal oxide in said second powder and said metal fluoride in said fourth powder are represented by the molecular formulas

of $Lu_2O_3$, BaO and $CuF_2$, respectively, and in which said second powder further contains an alkaline earth metal oxide represented by the molecular formula of SrO.

27. A process of producing a sintered superconductive ceramic material as set forth in claim 26, in which said mixture holds about 21.80 % of the oxygen compound of said rare earth metal by weight, about 28.91 % of said alkaline earth metal oxide represented by the molecular formula of BaO by weight, about 23.21 % of said alkaline earth metal oxide represented by the molecular formula of SrO by weight, and about 0.20 % of said metal fluoride by weight, respectively.

28. A process of producing a sintered superconductive ceramic material as set forth in claim 1, in which the metal fluoride content of said mixture ranges from about 1 % to about 20 % by weight.

29. A process of producing a sintered superconductive ceramic material as set forth in claim 28, in which said oxygen compound of said rare earth metal in said first powder, said alkaline earth metal carbonate in said second powder and said metal fluoride in said fourth powder are respectively represented by the molecular formulas of $Y_2O_3$, $BaCO_3$ and $BaF_2$.

30. A process of producing a sintered superconductive ceramic material as set fourth in claim 29, in which said mixture holds about 15.2 % of the oxygen compound of said rare earth metal by weight, about 52.3 % of said alkaline earth metal carbonate by weight and about 1 % of said metal fluoride by weight, respectively.

31. A process of producing a sintered superconductive ceramic material as set forth in claim 29, in which said mixture holds about 15.2 % of the oxygen compound of said rare earth metal by weight, about 50.8 % of said alkaline earth metal carbonate by weight and about 2 % of said metal fluoride by weight, respectively.

32. A process of producing a sintered superconductive ceramic material as set fourth in claim 29, in which said mixture holds about 15.2 % of the oxygen compound of said rare earth metal by weight, about 47.6 % of said alkaline earth metal carbonate by weight and about 5 % of said metal fluoride by weight, respectively.

33. A process of producing a sintered superconductive ceramic material as set forth in claim 29, in which said mixture holds about 15.3 % of the oxygen compound of said rare earth metal by weight, about 42.2 % of said alkaline earth metal carbonate by weight and about 10 % of said metal fluoride by weight, respectively.

34. A process of producing a sintered superconductive ceramic material as set fourth in claim 29, in which said mixture holds about 15.4 % of the oxygen compound of said rare earth metal by weight, about 36.7 % of said alkaline earth metal carbonate by weight and about 15 % of said metal fluoride by weight, respectively.

35. A process of producing a sintered superconductive ceramic material as set forth in claim 29, in which said mixture holds about 15.5 % of the oxygen compound of said rare earth metal by weight, about 31.2 % of said alkaline earth metal carbonate by weight and about 20 % of said metal fluoride by weight, respectively.

36. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Y_2O_3$, BaO and $BaF_2$.

37. A process of producing a sintered superconductive ceramic material as set forth in claim 36, in which said mixture holds about 16.9 % of the oxygen compound of said rare earth metal by weight, about 37.3 % of said alkaline earth metal oxide by weight and about 10 % of said metal fluoride by weight, respectively.

38. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Er_2O_3$, BaO and $YF_3$.

39. A process of producing a sintered superconductive ceramic material as set forth in claim 38, in which said mixture holds about 13.7 % of the oxygen compound of said rare earth metal by weight, about 42.9 % of said alkaline earth metal oxide by weight and about 10 % of said metal fluoride by weight, respectively.

40. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Dy_2O_3$, BaO and $CuF_2$.

41. A process of producing a sintered superconductive ceramic material as set forth in claim 40, in which said mixture holds about 24.9 % of the oxygen compound of said rare earth metal by weight, about 41.0 % of said alkaline earth metal oxide by weight and about 10 % of said metal fluoride by weight, respectively.

42. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Yb_2O_3$, BaO and $BaF_2$.

43. A process of producing a sintered superconductive ceramic material as set forth in claim 42, in which said mixture holds about 26.2 % of the oxygen compound of said rare earth metal by weight, about 32.0 % of said alkaline earth metal oxide by weight and about 10 % of said metal fluoride by weight, respectively.

44. A process of producing a sintered superconductive ceramic material as set forth in claim 28, in which said oxygen compound of said rare earth metal in said first powder, said alkaline earth metal carbonate in said second powder and said metal fluoride in said fourth powder are represented by the molecular formulas of $Gd_2O_3$, $BaCO_3$ and $YF_3$, respectively, and in which said fourth powder further contains a metal fluoride represented by the molecular formula of $CuF_2$.

45. A process of producing a sintered superconductive ceramic material as set forth in claim 44, in which said mixture holds about 16.1 % of the oxygen compound of said rare earth metal by weight, about 48.5 % of said alkaline earth metal carbonate by weight, about 5 % of said metal fluoride represented by the molecular formula of $YF_3$ by weight, and about 5 % of said metal fluoride represented by the molecular formula of $CuF_2$, respectively.

46. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Tm_2O_3$, BaO and $YF_3$.

47. A process of producing a sintered superconductive ceramic material as set forth in claim 46, in which said mixture holds about 12.8 % of the oxygen compound of said rare earth metal by weight, about 43.0 % of said alkaline earth metal oxide by weight and about 10 % of said metal fluoride by weight, respectively.

48. A process of producing a sintered superconductive ceramic material as set forth in claim 28, in which said oxygen compound of said rare earth metal in said first powder, said alkaline earth metal carbonate in said second powder and said metal fluoride in said fourth powder are respectively represented by the molecular formulas of $Nd_2O_3$, $BaCO_3$ and $BaF_2$.

49. A process of producing a sintered superconductive ceramic material as set forth in claim 48, in which said mixture holds about 21.3 % of the oxygen compound of said rare earth metal by weight, about 38.6 % of said alkaline earth metal carbonate by weight and about 10 % of said metal fluoride by weight, respectively.

50. A process of producing a sintered superconductive ceramic material as set forth in claim 28, in which said oxygen compound of said rare earth metal in said first powder, said alkaline earth metal carbonate in said second powder and said metal fluoride in said fourth powder are represented by the molecular formulas of $Lu_2O_3$, $BaCO_3$ and $BaF_2$, respectively, and in which said fourth powder further contains a metal fluoride represented by the molecular formula of $CuF_2$.

51. A process of producing a sintered superconductive ceramic material as set forth in claim 50, in which said mixture holds about 23.8 % of the oxygen compound of said rare earth metal by weight, about 41.6 % of said alkaline earth metal carbonate by weight, about 5 % of said metal fluoride represented by the molecular formula of $BaF_2$ by weight, and about 5 % of said metal fluoride represented by the molecular formula of $CuF_2$, respectively.

52. A process of producing a sintered superconductive ceramic material as set forth in claim 28, in which said oxygen compound of said rare earth metal in said first powder, said alkaline earth metal oxide in said second powder and said metal fluoride in said fourth powder are respectively represented by the molecular formulas of $Sm_2O_3$, BaO and $CuF_2$.

53. A process of producing a sintered superconductive ceramic material as set forth in claim 52, in which said mixture holds about 23.7 % of the oxygen compound of said rare earth metal by weight, about 41.7 % of said alkaline earth metal oxide by weight and about 10 % of said metal fluoride by weight, respectively.

54. A process of producing a sintered superconductive ceramic material as set forth in claim 28, in which said oxygen compound of said rare earth metal in said first powder, said alkaline earth metal oxide in said second powder and said metal fluoride in said fourth powder are represented by the molecular formulas of $Y_2O_3$, BaO and $BaF_2$, respectively, and in which said second powder further contains an alkaline earth metal oxide represented by the molecular formula of SrO.

55. A process of producing a sintered superconductive ceramic material as set forth in claim 54, in which said mixture holds about 15.8 % of the oxygen compound of said rare earth metal by weight, about 30.6 % of said alkaline earth metal oxide represented by the molecular formula of BaO, about 2.9 % of said alkaline earth metal oxide represented by the molecular formula of SrO by weight, and about 10 % of said metal fluoride by weight, respectively.

56. A process of producing a sintered superconductive ceramic material as set forth in claim 28, in which said oxygen compound of said rare earth metal in said first powder, said alkaline earth metal carbonate in said second powder and said metal fluoride in said fourth powder are represented by the molecular formulas of $Lu_2O_3$, $BaCO_3$ and $BaF_2$, respectively, and in which said second powder further contains an alkaline earth metal oxide represented by the molecular formula of CaO, wherein said fourth powder further contains a metal fluoride represented by the

molecular formula of $YF_3$.

57. A process of producing a sintered superconductive ceramic material as set forth in claim 56, in which said mixture holds about 18.1 % of the oxygen compound of said rare earth metal by weight, about 21.7 % of said alkaline earth metal carbonate by weight, about 0.7 % of said alkaline earth metal oxide by weight, about 5 % of said metal fluoride represented by the molecular formula of $BaF_2$ by weight, and about 5 % of said metal fluoride represented by the molecular formula of $YF_3$, respectively.

# INTERNATIONAL SEARCH REPORT

International Application No PCT/JP88/00956

**I. CLASSIFICATION OF SUBJECT MATTER** (if several classification symbols apply, indicate all) [6]

According to International Patent Classification (IPC) or to both National Classification and IPC

Int.Cl$^4$ C04B35/00, C01G3/00, H01B12/00

**II. FIELDS SEARCHED**

Minimum Documentation Searched [7]

| Classification System | Classification Symbols |
|---|---|
| IPC | C04B35/00, C01G3/00 |

Documentation Searched other than Minimum Documentation to the Extent that such Documents are Included in the Fields Searched [8]

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| Y | Physical Review Letters, Vol. 58, No. 20, (1987), S. R. Ovshinsky, et al [Superconductivity at 155K] P. 2579-2581 | 1-57 |
| Y | XVIII INTERNATIONAL CONFERRENCE ON LOW TEMPERATURE PHYSICS Conference Booklet (1987), T. S. Radhakrishnan, et al [Superconductivity studies on pure and F-containing La-M-Cu-O(M=Sr, Ba, Cd) system] P.245 | 1-57 |
| E | JP, A, 63-256518 (Mitsubishi Electric Corporation) 24 October 1988 (24. 10. 88) (Family: none) | 1-57 |
| A | Physical Review Letters, Vol. 58, No. 9, (1987), C. W. Chu, et al [Superconductivity at 93K in a New Mixed-Phase Y-Ba-Cu-O Compound System at Ambient Pressure] P.908-910 | 1-57 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| December 12, 1988 (12. 12. 88) | December 26, 1988 (26. 12. 88) |
| **International Searching Authority** | **Signature of Authorized Officer** |
| Japanese Patent Office | |